# EUROPEAN PATENT APPLICATION

(11) **EP 2 821 436 A1**
(43) Date of publication of application: **07.01.2015**
(21) Application number: 13189624.3
(22) Date of filing: 22.10.2013
(51) Int. Cl.: C08L 61/06, B24D 3/28, B24D 11/00, B32B 1/00, C07C 327/22, C08F 299/02, C09J 4/00, C08L 61/24, C08L 61/28, C08L 81/00, G03F 7/004, H05B 6/68

(54) **TRANSPARENT COMPOSITE COMPOSITION**

(30) Priority: 01.07.2013 US 201361841688 P
(71) Applicant: Allnex Belgium, S.A., 1070 Brussels (BE)
(72) Inventor: Cappelle, Steven, 9400 Ninove (BE); Vrijsen, Stijn, 1654 Huizingen (BE); Shaw, Jonathan, Acworth, GA Georgia 30101 (US)
(74) Representative: Schoofs, Hilde

(57) **Abstract**

The present invention relates to a transparent composite composition (a) comprising:
a. a resin composition, comprising
i. at least one (meth)acrylated oligomer (ia) and/or monomer (ib),
ii. at least one polythiol (ii), and
iii. optionally, one or more photo- and/or thermal initiators (iii), and

b. at least one transparent filler material (b).

The present invention further relates to its preparation and uses.

## Description

### Field of the invention

The present invention relates to the field of curable transparent composite compositions comprising a resin composition and a filler material; to their preparation and their uses.

### Background of the invention

Of all transparent materials which transmit radiant energy in the visible light spectrum, glass is the most commonly used as glazing material in buildings, vehicles, and the like. This is due to its high transparency, its hardness and resistance to abrasion, its relative chemical inertness and its relatively low price. However, glass is heavy and brittle, and may shatter upon impact. Additionally, glass is difficult to form into complex shapes.

For many applications there exists a need for mechanically strong composite materials that are of high optical quality and have an optical transparency similar to glass. Polymers such as polymethylmethacrylate (PMMA) are often used as a substitute to glass in applications in which both impact resistance and optical transparency are required. However, polymers such as PMMA still do not have sufficient mechanical strength for many applications. Such applications include for instance aircrafts windows and canopies.

For these types of applications, light weight transparent composite materials having excellent mechanical strength and not suffering from the brittleness of glass would be desirable.

Another application area for such transparent composites is the field of electronic devices. For instance, transparent composites can be used in displays, touch panels, optical elements, sensors, LED sealants, solar cells and so on. They receive interest in relation to mobile application because they can make electronic devices thin, light-weighted, robust, conformable and flexible. Ultra-thin glass and plastic films are also considered for these applications, though glass is too rigid and polymers have typically a too high coefficient of thermal expansion.

US2004/0126592 discloses a transparent composite composition foreseen for use as an optical sheet for a liquid crystal display device or organic electroluminescent display device. It comprises a transparent resin and a glass filler. The transparent resin is a copolymer obtained from the copolymerization of an acrylate having an alicyclic structure and at least one acrylate selected from among sulfur-containing acrylates and fluorine skeleton-containing acrylates. Such resins based only on acrylates tend however to have a relatively high residual stress after cross-linking which promote the formation of microcracks impacting negatively transparency and the mechanical properties.

### Summary of the invention

Against this background we now provide in a first aspect a transparent composite composition comprising:
I. a resin composition (a), comprising
   i. at least one (meth)acrylated oligomer (ia) and/or monomer (ib),
   ii. at least one polythiol (ii), and
   iii. optionally, one or more photo- and/or thermal initiators (iii), and
II. at least one transparent filler material (b).

Composite compositions of the present invention may present one or more of the following advantages:
- They may be suitable for obtaining composite articles having high transparency;
- They may be suitable for obtaining composite articles having a low haze;
- They may be suitable for obtaining composite articles experiencing little stress upon curing, thereby preventing the induction of microcracks which impact negatively transparency and mechanical properties;
- they may be used to form a large variety of composite articles;
- they may be free of bisphenol A which is toxic; and
- generally, they may have a low toxicity.

In a second aspect, the present invention relates to a transparent composite article comprising :
a. a resin matrix (a') obtainable from the crosslinking of:
   i. at least one (meth)acrylated oligomer (ia) and/or monomer (ib),
   ii. at least one polythiol (ii),
   optionally in the presence of one or more photo- and/or thermal initiators (iii), and
b. at least one transparent filler material (b) within said resin matrix (a').

Composite articles of the invention may present one or more of the following advantages:
- They may have low residual stress;
- They may have high transparency;
- They may have low haze,
- They may have excellent mechanical strength; and
- They may have a low tendency to break.

In a third aspect, the present invention relates to a process for forming a composite composition according to any embodiment of the first aspect, comprising contacting:
I. a resin composition (a), and
II. a transparent filler material (b), the resin composition (a) comprising:
   i. at least one (meth)acrylated oligomer (ia) and/or monomer (ib),
   ii. at least one polythiol (ii), and
   iii. optionally, one or more photo- and/or thermal initiators (iii).

This process involving said resin composition (a) may present one or more of the following advantages:
- The resin composition (a) may have a good pot life even at room temperature;
- The storing costs of the resin composition may be low; and
- The support complexity for the resin composition storage may be low.

In a fourth aspect, the present invention relates to a process for forming a transparent composite article comprising curing the composite composition according to any embodiment of the first aspect.

This may present one or more of the following advantages:
- It may be fast;
- It may be performed at low temperature;
- It may be performed on demand, thereby facilitating handling in industrial production;
- It may be cost effective;
- It may require a low energy consumption; and
- It may be easy to perform even for producing parts of high complexity and/or size.

In a fifth aspect, the present invention relates to a resin composition (a) comprising
ia. optionally at least one (meth)acrylated oligomer (ia),
ib. at least one (meth)acrylated monomer (ib),
ii. at least one polythiol (ii), and
iii. optionally, one or more photo- and/or thermal initiators (iii),
   wherein at least one of said at least one (meth)acrylated monomer (ib) is prepared from:
   (d) at least one polycyclic polyol (d),
   (e) optionally, at least one linking compound (e) for linking said at least one polycyclic polyol (d) with a (meth)acrylating compound (f), and
   (f) at least one (meth)acrylating compound.

Such a resin composition (a) may have the advantage to be particularly well suited for use with a transparent filler material (b) to obtain a composite composition according to the first aspect experiencing little shrinkage upon curing, little yellowing upon aging and excellent transparency and color neutrality.

In a sixth aspect, the present invention relates to a kit of parts comprising
a. a resin composition (a), comprising
   i. at least one (meth)acrylated oligomer (ia) and/or monomer (ib),
   ii. at least one polythiol (ii), and
   iii. optionally, one or more photo- and/or thermal initiators (iii), and
b. at least one transparent filler material (b).

In a seventh aspect, the present invention relates to a substrate coated with a composite composition according to the first aspect of the present invention. The composite composition can be cured or not cured. When cured, it may form a protective layer above said substrate.

### Brief description of the drawing

Fig.1 schematically represents a method for forming a composite article according to an embodiment of the present invention.

### Definitions

As used herein and unless provided otherwise, the term *"(meth)acrylate"* must be construed as meaning methacrylate or acrylate.

As used herein and unless provided otherwise, the term *"polycyclic compounds"* relates to compounds comprising at least two fused rings.

### Detailed description of the invention

In a first aspect, the present invention relates to a transparent composite composition comprising:
a. a resin composition (a), comprising
   i. at least one (meth)acrylated oligomer (ia) and/or monomer (ib),
   ii. at least one polythiol (ii), and
   iii. optionally, one or more photo- and/or thermal initiators (iii), and
b. at least one transparent filler material (b).

By a "transparent composite composition" is meant to designate in the context of the invention a composition that after curing becomes transparent.

In an embodiment, the composite composition may have after curing, a haze of less than 12% when formed into a composite sheet of 800 µm thickness.

In an embodiment, the composite composition may have after curing, a light transmittance of at least 60%, preferably at least 70%, more preferably at least 80% measured at a wavelength of 550 nm when formed into a composite sheet of 800 µm thickness.

In an embodiment, the composite composition may have after curing, a light transmittance of at least 40%, preferably at least 50%, more preferably at least 55% measured at a wavelength of 400 nm when formed into a composite sheet of 800 µm thickness.

In an embodiment, the flexural modulus of the cured composite composition may be from 8 to 20 GPa, preferably from 9 to 17 GPa at 20°C.

In an embodiment, the flexural strength of the cured composite composition may be from 200 to 500 MPa, preferably from 250 to 460 MPa at 20°C.

The resin composition (a) in the framework of the invention is one that is suitable for combining with a transparent filler material (b) so that after curing of the composite composition a transparent composite material is obtained.

In an embodiment, the resin composition (a) may have a first refractive index after curing, wherein the transparent filler material (b) has a second refractive index, and wherein the first refractive index is within 0.01, preferably within 0.005, yet more preferably within 0.003, and most preferably within 0.001 of the second refractive index. For instance, if the second refractive index is 1.52 and said first refractive index is within 0.01 of said second refractive index, this means that the first refractive index is from 1.51 to 1.53.

Having the first and the second refractive index matching each other closely is advantageous as it permits to obtain a composite article having a very low haze.

In an embodiment, the resin composition (a) may, after cure, have a Tg of at least 30°C so as to lead to self supporting articles at room temperature. However, much preferred is a resin composition having a Tg of at least 60°C in order to assure thermal stability to the article across a broad range of usage conditions.

In an embodiment, the resin composition (a) may, upon cure, show a volume contraction of maximum 10.0%, preferably maximum 9.0%, more preferably maximum 8.0%, yet more preferably maximum 7.8%

In an embodiment, the resin composition (a) may, after cure, show a residual stress of less than 5 MPa, preferably less than 4 MPa, more preferably less than 3 MPa and most preferably less than 2 MPa. Typically, the amount of residual stress will be between 1 and 2 MPa, more typically 1.5 and 2 MPa.

In an embodiment, the resin composition (a) may have a viscosity at 25°C of from 150 to 40,000 mPa.s, preferably from 150 to 10,000 mPa.s, more preferably from 200 to 5,000 mPa.s.

In the first aspect, the amount of (meth)acrylated oligomer (ia) and/or monomer (ib) in the resin composition may be from 60 to 99.5 wt%, preferably from 70 to 99 wt%, more preferably from 75 to 95 wt%.

In an embodiment, said at least one (meth)acrylated oligomer (ia) and/or monomer (ib) may be chosen so that the glass transition temperature of the polymer obtainable from the polymerization of only said at least one (meth)acrylated oligomer (ia) and/or monomer (ib) is greater than 60°C, preferably greater than 70°C, more preferably greater than 80°C, and yet more preferably greater than 90°C. This is advantageous as it imparts higher thermal resistance to the composite article.

The (meth)acrylated oligomers (ia) are typically composed of only a few monomer units such as a dimer, trimer, tetramer etc. They may typically be defined as being composed of repeating monomer units and as having a molecular weight (MW) between 500 and 20,000 Daltons.

In embodiments, the (meth)acrylated oligomers (ia) may typically be viscous liquids with a viscosity ranging from about 500 to greater than one million mPa.s at 25°C (e.g. up to 1.5 million mPa.s).

For instance, their viscosity may range from 500 to 1,500,000 mPa.s at 25°C. Preferably, their viscosity may be from 2,000 to 100,000 mPa.s at 25°C, more preferably from 2,000 to 50,000 mPa.s at 25°C, yet more preferably from 2,000 to 20,000 mPa.s at 25°C.

In an embodiment of the first aspect, the at least one (meth)acrylated oligomer (ia) and/or monomer (ib) may comprise or be at least one di (meth)acrylated oligomer (ia) and/or monomer (ib).
The (meth)acrylated oligomers (ia) can vary widely, and may include a variety of backbone structures in addition to the radiation curable moiety, such as but not limited to urethane, epoxy, polyester, polyether or acrylic.

In an embodiment, said one or more (meth)acrylate oligomers (ia) may be selected from the list consisting of epoxy (meth)acrylate oligomers, urethane (meth)acrylate oligomers, polyester (meth)acrylate oligomers, polyether (meth)acrylate oligomers, (meth)acrylated (meth)acrylics oligomers, (meth)acrylic (co)polymers oligomers, alkoxylated (meth)acrylate oligomers, aminated (meth)acrylate oligomers, and combinations thereof.

In an embodiment, said one or more (meth)acrylate oligomers (ia) may be selected from the list consisting of epoxy (meth)acrylate oligomers, urethane (meth)acrylate oligomers, polyester (meth)acrylate oligomers, polyether (meth)acrylate oligomers, (meth)acrylic (co)polymers oligomers, aminated (meth)acrylate oligomers, and combinations thereof.

Examples of suitable epoxy (meth)acrylate oligomers are the di(meth)acrylate of diglycidyl ether of Bisphenol A (BADGED(M)A), and modifications thereof (see for instance EBECRYL® 3700 or EBECRYL® 600, EBECRYL® 3701, EBECRYL® 3703, EBECRYL® 3708, EBECRYL® 3720 and EBECRYL® 3639 (all available from Cytec)). Other types of epoxy acrylate oligomers include EBECRYL® 860 (epoxidized soya oil acrylate available from Cytec) and Maleinated Acrylated Epoxidized Oils (MAESO, MAELO).

Examples of suitable urethane (meth)acrylate oligomers are EBECRYL® 284, EBECRYL® 294, EBECRYL® 264, EBECRYL® 210, EBECRYL® 220, EBECRYL® 230, EBECRYL® 4858, EBECRYL® 8701, EBECRYL® 8402, EBECRYL® 8405, EBECRYL® 8465, EBECRYL® 8301, and EBECRYL® 1290 (all available from Cytec).

Examples of suitable polyester (meth)acrylate oligomers are fatty acid containing polyester (meth)acrylates like EBECRYL® 870, EBECRYL® 657, and EBECRYL® 450 (all available from Cytec), and polyester (meth)acrylates like EBECRYL® 800, EBECRYL® 884, EBECRYL® 885, EBECRYL® 810 and EBECRYL® 830 (all available from Cytec).

Examples of suitable polyether (meth)acrylate oligomers are oligoethylene glycol di(meth)acrylate and tri(meth)acrylate (e.g. di, tri or tetra ethylene glycol di(meth)acrylate, or tetra ethylene glycol tri(meth)acrylate) and oligopropylene glycol di(meth)acrylate (e.g. di or tri propylene glycol di(meth)acrylate).

Examples of suitable aminated (meth)acrylate oligomers are EBECRYL® 80, EBECRYL® 81, EBECRYL® 83, EBECRYL® 7100, EBECRYL®P115, EBECRYL® P116 (all available from Cytec) and others.

Examples of suitable (meth)acrylic (co)polymer oligomers that may be used are EBECRYL® 745 and/or EBECRYL® 1200 (all available from Cytec).

In embodiments, the (meth)acrylated monomers (ib) may be monofunctional, difunctional, or trifunctional, tetrafunctinal, pentafunctional or hexafunctional(meth)acrylate monomers. Representative examples of such monomers include but are not limited to: (meth)acrylic acid, ethylene glycol di(meth)acrylate, ethoxylated bisphenol A di(meth)acrylate esters, isosorbide di(meth)acrylate, tris(2-hydroxyethyl) isocyanurate tri(meth)acrylate as well as the di(meth)acrylate, alkyl (such as isobornyl, isodecyl, isobutyl, n-butyl, t-buyl, methyl, ethyl, tetrahydrofurfuryl, cyclohexyl, n-hexyl, iso-octyl, 2-ethylhexyl, n-lauryl, octyl or decyl) or hydroxy alkyl (such as 2-hydroxyethyl and hydroxy propyl) esters of acrylic acid or methacrylic acid, phenoxyethyl(meth)acrylate, nonylphenolethoxylate mono(meth)acrylate, 2-(-2-ethoxyethoxy)ethyl(meth)acrylate, 2-butoxyethyl(meth)acrylate, butyleneglycol di(meth)acrylate and tri(meth)acrylate, 1,6-hexanediol di(meth)acrylate, ethoxylated and/or propoxylated hexanediol di(meth)acrylate, methacrylated fatty acid, glycerol tri(meth)acrylate and the ethoxylated and/or propoxylated derivatives thereof, bisphenol A di(meth)acrylate and tri(meth)acrylate and the ethoxylated and/or propoxylated derivatives thereof, tricyclodecanedi(meth)acrylate, tricyclodecanedimethanol di(meth)acrylate, pentaerythritol di(meth)acrylate and tri(meth)acrylate and tetra(meth)acrylate and the ethoxylated and/or propoxylated derivatives thereof, propylene glycol di(meth)acrylate, neopentyl glycol di(meth)acrylate, ethoxylated and/or propoxylated neopentylglycol di(meth)acrylate, hexamethylene glycol di(meth)acrylate, 4,4'-bis(2-acryloyloxyethoxy)diphenylpropane, di- or trimethylolpropane tri(meth)acrylate, phenylglycidylether(meth)acrylate and the ethoxylated or/and propoxylated derivatives thereof, the (meth)acrylates obtained from the esterification with (meth)acrylic acid of aliphatic glycidyl ethers, especially those wherein the alkyl chain comprises from 6 to 24 carbon atoms, more preferably from 8 to 18 carbon atoms, and/or of glycidyl esters of saturated and unsaturated carboxylic acids, especially the glycidyl esters of long chain alkyl carboxylic acids wherein the alkyl chain comprises from 6 to 24 carbon atoms, more preferably from 8 to 18 carbon atoms, and combinations thereof.

As an example, the (meth)acrylated monomer (ib) may be a polycyclic acrylate such as isosorbide diacrylate (synthetic example 4) or isobornyl acrylate available from Cytec.

In an embodiment of the first aspect, the amount of (meth)acrylated monomer (ib) in the resin composition may be 95 wt% or less, preferably 90 wt% or less, more preferably, 85wt% or less, yet more preferably 80wt%.

For instance, the amount of (meth)acrylated monomer (ib) in the resin composition may be from 0 to 95wt% or from 0 to 80wt%.

In some embodiments, the amount of (meth)acrylated monomer (ib) if present in the resin composition may be 1wt% or more, 10% or more, 25% or more, 40% or more, or 50% or more. Any minimal amount cited above may be combined with any maximal amount cited above. For instance, the amount of (meth)acrylated monomer (ib) in the resin composition may be 1wt% or more and 80wt% or less.

Preferably, (Meth)acrylated monomer (ib) does not absorb visible light. Preferably, (Meth)acrylated monomer (ib) does not comprise aromatic moieties.

(Meth)acrylated monomer (ib) may have an interesting viscosity lowering effect. However, most such monomers usually impact negatively the shrinkage of the liquid composition upon curing. This may lead to warpage and poor part fit-up. For this reason, it may be advantageous in some embodiments of the present invention, to use as one of the at least one (meth)acrylated monomer (ib), a polycyclic (meth)acrylated monomer (ib). Examples of polycyclic (meth)acrylated monomers (ib) are isobornyl (meth)acrylate, dicyclopentadienyl (meth)acrylate, tricyclodecanedi(meth)acrylate, tricyclodecanedimethanol di(meth)acrylate, adamantyl (meth)acrylate, isosorbide di(meth)acrylate and isopinocamphyl (meth)acrylate. Preferably, a polycyclic ether (meth)acrylated monomer (ib) may be used. For instance, the polycyclic (meth)acrylated monomer (ib) may be obtained from the reaction of components (d), (f), and optionally (e) as described below.

In an embodiment, at least one of the (meth)acrylated monomer (ib) may be prepared from:
(d) at least one polycyclic polyol (d) (preferably at least one polycylic ether polyol),
(e) optionally, at least one linking compound (e1) for linking said at least one polycyclic polyol (d) with at least one (meth)acrylating compound (f), and
(f) said at least one (meth)acrylating compound (f).

The (meth)acrylated monomer (ib) obtained from the reaction of components (d), (f), and optionally (e) have the advantage to resist shrinkage and therefore to higher the thermal resistance of the resin. Furthermore, the inventors have observed that such (meth)acrylated monomers (ib) obtained from the reaction of components (d), (f), and optionally (e) appears not to impact the transparency or color neutrality of the cured resin. Without being bound by theory, it is hypothesized that these unique properties observed with such monomers might be due to their rigid but non-aromatic nature.

When present, the (meth)acrylated monomer (ib) obtained from the reaction of components (d), (f), and optionally (e) may be present in an amount of from 30wt% or more, preferably 40wt% or more, more preferably 50wt% or more and most preferably 60wt% or more and up to 100wt% of the total amount of (meth)acrylated monomer (ib) in the resin.

Polycyclic polyols (d) are compounds having at least one polycyclic group and at least two hydroxyl groups.

In an embodiment, the at least one polycyclic ether polyol (d) may be selected from dicyclic ether polyol and tricyclic ether polyols. Preferably, the at least one polycyclic ether polyol is at least one dicyclic ether polyol.

In an embodiment of the first aspect, the polycyclic ether polyol (d) may be derived from a renewable origin. In other words, preferred polycyclic ether polyols (d) may be bioderived polycyclic ether polyols that are compounds derived from a renewable biological feedstock, such as, for example, agricultural, forestry, plant, bacterial or animal feedstock. This has obvious ecological advantages.

An example of such a polycyclic ether polyol (d) may be a dianhydrohexitol sugar diol.

Examples of dianhydrohexitol are dianhydromannitol, dianhydrosorbitol, dianhydroiditol and mixtures thereof. The dianhydrohexitol is preferably dianhydrosorbitol, most preferably, isosorbide. A few companies have specialized in their production. We found these compounds to have the surprising effect to higher the thermal resistance and limit the shrinkage of the resulting composite compositions upon curing. As an example, the polycyclic ether polyol (d) may be the isosorbide diol available at Roquette under the trade name Polysorb P.

In an embodiment of the first aspect, said at least one polycyclic polyol (d) may be selected so that the homopolymer (typically formed after crosslinking) of the corresponding (meth)acrylated monomer (ib) has a glass transition temperature of at least 130°C. (Meth)acrylated monomer (ib) prepared from such polycyclic polyol are advantageous because they impart higher thermal resistance to the composite composition.

In an embodiment, said at least one linking compound (e) may be at least one linking compound (e1) and/or (e2), wherein the linking compound (e1) is selected from cyclic compounds (e11) containing at least one -C(O)-X- group in the cycle where X = O or NH, from hydroxy acids (e12) and/or from alkylene oxides (e13) containing from 2 to 4 carbon atoms, and wherein the linking compound (e2) is selected from epihalohydrins or polyisocyanates, wherein if both compounds (e1) and (e2) are being used, compound (e1) forms a moiety that links the polycyclic polyol (d) to the linking compound (e2) which attaches to the (meth)acrylating compound (f).

By linking compound (e1) is meant to designate a compound capable of forming a moiety that links the polycyclic polyol (d) to either the linking compound (e2) where present or to the (meth)acrylating agent (f). Compound (e1) bears at least one group reactive towards hydroxyl groups and at least one group reactive towards either the linking compound (e2) or the (meth)acrylating agent (f). This last group can be originally present on compound (e1) or be the result of the reaction of (e1) with the polyol. Compound (e1) is generally selected from cyclic compounds (e11) containing at least one group in the cycle where X = O or NH, from hydroxyl acids such as glycolic and/or lactic acid (e12) and/or from alkylene oxides (e13) containing from 2 to 4 carbon atoms.

Compound (e11) is advantageously a compound wherein X is oxygen. Suitable cyclic compounds (e11) include lactones, lactams, lactides, glycolides, cyclic carbonates and mixtures thereof.

Preferred cyclic compounds (e11) are lactones, lactides, and mixtures thereof.

Particularly preferred lactones are ε-caprolactone, δ-valerolactone, γ-butyrolactone, and lactones of hydroxycarboxylic acids such as 2-hydroxycarboxylic acids, e.g. glycolic acid and lactic acid, 3-hydroxycarboxylic acids, e.g. 3-hydroxypropionic acid, 3-hydroxybutyric acid, 3-hydroxyvaleric acid and hydroxypivalic acid. More preferred are ε-caprolactone, δ-valerolactone, γ-butyrolactone and mixtures thereof, most preferred is ε-caprolactone. Particularly preferred lactides are L-, meso- and/or D-lactide and mixtures thereof. More preferred cyclic compounds (e11) are lactides. Lactides are advantageously bioderived lactides.
Compound (e12) is a hydroxy acid. This means that it is a compound bearing one hydroxyl group and one carboxylic acid group. Compound (e12) may correspond to the open form of the above listed lactones. Preferred compounds (e12) are glycolic acid also named hydroxyacetic acid and lactic acid also named 3-hydroxypropionic acid.

Suitable compounds (e13) include ethylene oxide, propylene oxide, butylene oxide and mixtures thereof. Preferred are ethylene oxide, propylene oxide and mixtures thereof.
Linking compound (e2)_is typically selected from epihalohydrins or polyisocyanates.

Epihalohydrins are compounds having a halomethyl oxirane skeleton (scheme 1) wherein X is a halogen atom.

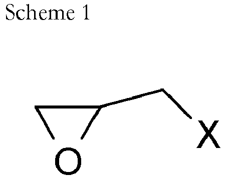

Preferred epihalohydrins are epifluorohydrin, epichlorohydrin (also known as epichlorhydrin), epibromohydrin, and/or epiiodohydrin. More preferred is epichlorohydrin.

For example, at least one of the (meth)acrylated monomer (ib) may be selected from the di(meth)acrylate of a dianhydrohexiol and the ethoxylated and/or propoxylated derivatives thereof.
Example of such a (meth)acrylated monomers (ib) are isosorbide diacrylate, isosorbide dimethacrylate and ethoxylated and/or propoxylated derivatives thereof.

(Meth)acrylated monomers (ib) of this family are advantageous because they impart increased thermal resistance wherein little shrinkage occurs upon curing, thereby preventing warpage and/or poor part fitting. Furthermore, they do not impact negatively the transparency or color neutrality of the cured composite article.

In an embodiment wherein at least one of the monomers is prepared from (d), (e) and (f), the sum of (d), (e) and (f) in the composition of this (meth)acrylated monomer (ib) may represent at least 90 mol% and preferably at least 95 mol% of the building blocks entering the preparation of this (meth)acrylated monomer (ib). In these embodiments, this (meth)acrylated monomer may be said to be prepared from at least building blocks (d) and (f), and optionally building block (e) and/or other building blocks. More preferably, the sum of (d), (e) and (f) represents 100 mol% of the building blocks entering the preparation of this (meth)acrylated monomer (ib). In this embodiment, (ib) may be said to be directly prepared from (d), (f) and optionally (e). As an optional feature, at least one compound (e2) is used, if a compound (e13) is being used.

Preferably, no linking compound is used.

In a preferred embodiment, linking compound (e) is not present.

In an embodiment, at least one of the (meth)acrylated monomer (ib) may have a high renewable content. This is typically the case for (meth)acrylated monomers obtained from (d), (f) and optionally (e) wherein (d) is a polycyclic ether. For instance such a (meth)acrylated monomer (ib) can be prepared wherein at least 1% by weight, at least 2% by weight, at least 5% by weight, at least 10% by weight, even at least 20% by weight of the raw materials used to prepare said compound are from renewable origin, i.e. derived from a renewable biological feedstock, such as, for example, agricultural, forestry, plant, bacterial or animal feedstock. This has obvious ecological advantages.

By (meth)acrylating compound (f) is meant to designate a compound comprising at least one (meth)acryloyl group and at least one group reactive towards compounds (d), (e1) or (e2), depending on the compounds used for the preparation of the (meth)acrylated monomer (ib), or towards the reaction products of (e1) or (e2) with the polycyclic polyol (d). Typically (meth)acrylating compounds (f) are selected from compounds (f1) and/or from compounds (f2).
Compounds (f1) are selected from unsaturated acids and suitable equivalent thereof.

Examples of suitable equivalents are for instance the acyl halide of the unsaturated acid, the corresponding anhydride of the unsaturated acid and/or a lower alkyl ester of the unsaturated acid. With lower alkyl is meant a C₁-C₄ alkyl. Particularly suited for use in the present invention are (meth)acrylic acid, (meth)acrylic acid anhydride, a (meth)acrylic acid halide, and/or a lower alkyl ester of (meth)acrylic acid. Examples of suitable (meth)acrylic acid halides are (meth)acrylic acid chloride, (meth)acrylic acid bromide and/or (meth)acrylic acid iodide. By a lower alkyl ester is meant to designate in particular the lower alcohol ester of an unsaturated acid such as (meth)acrylic acid. The lower alcohol preferably is an aliphatic C₁-C₄ alcohol. Preferred lower alkyl esters are for instance methyl esters, ethyl esters, n-propyl esters and/or isopropyl esters of (meth)acrylic acid. When a (meth)acrylic acid halide and/or (meth)acrylic acid anhydride is used, it is desirable to work in anhydrous conditions to avoid compounds hydrolysis. Preferred for use in the invention are unsaturated monoacids. A most preferred compound (f1) is (meth)acrylic acid (methacrylic acid or acrylic acid).

Compounds (f2) are compounds that contain at least one reactive group capable to react with isocyanate groups as well as at least one (meth)acryloyl group. Typically compounds (f2) are compounds that contain at least one (meth)acryoyl group and one (or essentially one) nucleophilic function capable of reacting with isocyanate groups, such as a hydroxyl group.

Other possible groups are amino and/or thiol groups. Hydroxyl groups though are preferred. Useful compounds (f2) include the esterification products of aliphatic and/or aromatic polyols with (meth)acrylic acid having a residual average hydroxyl functionality of about 1.

Mono(meth)acryloyl mono-hydroxy compounds as well as poly(meth)acryloyl mono-hydroxy compounds can be used.

Preferred mono(meth)acryloyl mono-hydroxy compounds are hydroxymethyl (meth)acrylate, hydroxyethyl (meth)acrylate, hydroxypropyl (meth)acrylate and/or hydroxybutyl (meth)acrylate. More preferred are the acrylate derivatives.

Preferred examples of poly(meth)acryloyl mono-hydroxy compounds are compounds comprising at least two (meth)acryl functions such as glycerol di(meth)acrylate, trimethylolpropane di(meth)acrylate, glycerol di(meth)acrylate, pentaerythritol tri(meth)acrylate, ditrimethylolpropane tri(meth)acrylate, dipentaerythritol penta(meth)acrylate and their (poly)ethoxylated and/or (poly)propoxylated equivalents. More preferred poly(meth)acryloyl mono-hydroxy compounds are glycerol di(meth)acrylate, trimethylolpropane di(meth)acrylate.

Most preferred are the acrylate derivatives.

In this context, it is also possible to use reaction products of such polyols with ethylene oxide, propylene oxide and/or lactones, which add to these polyols in a ring-opening reaction.

Examples of suitable lactones are ε-caprolactone, δ-valerolactone, γ-butyrolactone.

Glycolides and lactides can be used for the same purpose. These modified or unmodified polyols are partly esterified with acrylic acid, methacrylic acid or mixtures thereof until the desired residual hydroxyl functionality is reached. Examples of useful compounds in this category are Tone™ M100 (available from Dow Chemicals), Bisomer PEMCURE™ 12A (available from Cognis) and/or the reaction products (or adducts) of a (meth)acryloyl hydroxy compound and for instance Galacid™ Slow release (available from GALACTIC SA), FUTERRO® Lactide LF (available from Futerro), PURALACT® L, PURALACT® D or PURASORB ® G (available from Purac), or mixtures of any of these.

Compounds (f2) obtained from the reaction of (meth)acrylic acid with aliphatic, cycloaliphatic or aromatic compounds bearing an epoxy functionality, forming a compound bearing a hydroxyl functionality together with at least one (meth)acrylic functionality can be used as well.

Most preferred compounds (f2) are hydroxyethylacrylate, glycerol diacrylate, trimethylolpropane diacrylate and mixtures thereof.

Preferably, no linking compound is present. When no linking compound is present, compound (ib) may be prepared by a condensation reaction of a polycyclic polyol with a compound (f1) e.g. (meth)acrylic acid.

In some embodiments, a linking compound may be present.

In a particular embodiment wherein a linking compound is present, the (meth)acrylated monomer (ib) may be prepared from a polycyclic polyol (d), a linking compound (e2) selected from epihalohydrins and a (meth)acrylating compound (f1) selected from unsaturated acids. In this first embodiment, the compound (e2) links the polycyclic polyol (d) to the (meth)acrylating compound (f1). Compound (ib) according to this first embodiment can be prepared in different ways. The compound (ib) may for instance be prepared by a process comprising a first step wherein the polycyclic polyol is reacted with the epihalohydrin to form a product having one or more epoxy groups, and a second step comprising the reaction of the product obtained in the first step with one or more suitable (meth)acrylating compounds. The reaction is generally conducted under heat and in the presence of one or more catalysts.

Although solvent is not required, it may be used to facilitate the heat and mass transfer and one or more polymerization inhibitors may be added during or after the reaction. Depending on the reaction conditions and reaction stoichiometry, the reaction of the polycyclic polyol (d) with the linking compound (e2) can lead to an extended structure comprising the repetition of (d)-(e2) links and terminated by epoxy groups. However, the preferred structures are not extended. After reaction with the (meth)acrylating compound (e2), the preferred (meth)acrylated compound (ib) contains essentially no residual epoxy group. Typically, the (meth)acrylated monomer (ib) has a residual epoxy value below 0.1 milliequivalent per gram of compound (ib).

In another particular embodiment wherein a linking compound is present, the (meth)acrylated monomer (ib) may be prepared from a polycyclic polyol (d), a linking compound (e2) selected from polyisocyanates, a (meth)acrylating compound selected from (f2) compounds. In this second embodiment, the compound (e2) links the polycyclic polyol (d) to the (meth)acrylating compound (f2). (Meth)acrylated monomer (ib) according to this second embodiment can be produced in many ways. For example, compounds (d), (e2) and (f2) may be reacted together at once. Alternatively, monomer (ib) may be made by pre-reacting a polyisocyanate (e2) with a (meth)acrylating compound (f2) to form an adduct with at least one free isocyanate group, which is later reacted with a polycyclic polyol (d); or a polycyclic polyol (d) and polyisocyanate (e2) may be reacted first and this product reacted further with a (meth)acrylating compound (f2). The reaction is generally conducted under heat and in the presence of one or more catalysts. Although solvent is not required, it may be used to facilitate the heat and mass transfer and one or more polymerization inhibitors may be added during or after the reaction.

Depending on the reaction conditions and reaction stoichiometry, the reaction of the polycyclic polyol (d) with the linking compound (e2) can lead to an extended structure comprising the repetition of (d)-(e2) links and terminated by isocyanate groups. However, the preferred structures are not extended. After reaction with the (meth)acrylating compound (e2), the preferred (meth)acrylated compound (ib) contains essentially no residual isocyanate group.

Typically, the (meth)acrylated monomer (ib) may have a residual isocyanate value below 0.2 % NCO.

In a variant of these two first embodiments wherein a linking compound is present, a linking compound (e1) is further used for the preparation of the (meth)acrylated compound (ib).

The linking compound (e1) is typically selected from compounds (e11), from (e12) and/or from (e13), preferably from (e11) compounds. Preferred compounds (e11) are selected from lactones, lactams, lactides, glycolides, cyclic carbonates and mixtures thereof, more preferred compounds (e11) are selected from lactones and lactides and mixtures thereof, most preferred are selected from lactides. In this variant, compound (e1) forms a moiety that links the polycyclic polyol (d) to the linking compound (e2) that also links to the (meth)acrylating compound (f) in a sequence:
(a)*-(e1)*-(e2)*-(f)*, wherein
(a)*, (e2)* and (f)* are residues of respectively (d), (e2) and (f)
(e1)* is a moiety formed from (e1).

Compound (e1) has typically at least one group reactive towards hydroxyl groups and at least one group reactive towards the linking compound (e2). This last group can be originally present on compound (e1) or be the result of the reaction of (e1) with the polyol. The reactions between (d) and (e1) and between (e1) and (e2) can be conducted according to any suitable method. For instance, an adduct between the polycyclic polyol (d) and the linking compound (e1) may first be formed followed by the reaction with compound (e2) and compound (f). These steps are generally conducted under heat and in the presence of one or more catalysts. Although solvent is not required, it may be used to facilitate the heat and mass transfer and one or more polymerization inhibitors may be added during or after the reaction. As will be apparent to the skilled person, depending on the equivalent ratio of compound (e1) to the hydroxyl groups of the polycyclic polyol (d) and on the reaction conditions, some oligomerization or polymerization of compound (e1) can take place. The number of repeating units of the moiety (e1)* of the adduct is generally from 1 to 10, preferably from 1 to 5, more preferably from 1 to 2. These units are randomly spread over the hydroxyl groups of the polycyclic polyol (d).

In another particular embodiment of the present invention wherein a linker (e) is present, the (meth)acrylated compound (ib) may be prepared from a polycyclic polyol (d), a linking compound (e1) selected from compounds (e11) and/or from compounds (e12) and a (meth)acrylating compound (f1) selected from unsaturated acids and/or suitable equivalents thereof. In this third embodiment, the compound (e1) links the polycyclic polyol (d) to the (meth)acrylating compound (f1). Monomer (ib) according to this second embodiment can be produced in many ways. The monomer (ib) may for instance be prepared by a process comprising a first step wherein the polycyclic polyol is reacted with the linking compound (e1) selected from (e11) and/or (e12) as described in the variant supra to form an adduct, and a second step comprising the reaction of the adduct obtained in the first step with one or more suitable (meth)acrylating compounds (f1). The reaction is generally conducted under heat and in the presence of one or more catalysts. Although solvent is not required, it may be used to facilitate the heat and mass transfer and one or more polymerization inhibitors may be added during or after the reaction. In this embodiment, the number of repeating units of the formed moiety (e1)* of the adduct is generally from 1 to 10, preferably from 1 to 5, more preferably from 1 to 2. Preferred linking compounds (e1) of this embodiment are selected from (e11) compounds, more preferably from lactones, lactams, lactides, cyclic carbonates and mixtures thereof, most preferably from lactones and lactides and mixtures thereof.

In the first aspect, the amount of polythiol (ii) in the resin composition may be from 0.5 to 40 wt. %, preferably from 1 to 30 wt%, more preferably from 5 to 25 wt%.

In an embodiment, said polythiol (ii) may have a refractive index higher than the transparent filler material (b). In an embodiment, said at least one polythiol (ii) may have a refractive index of from 1.46 to 1.70.

Refractive indexes of the thiol compounds described are preferably between 1.5 and 1.65.

For instance, it may have a refractive index which is from 0.05 to 0.25 higher or from 0.10 to 0.20 higher than the filler. The polythiols used in the invention have at least two thiol groups and are preferably free of free-radically polymerizable groups. Useful polythiols are also preferably substantially free of disulfide linkages that would impart chemical and/or thermal instability to the crosslinked (or cured) network. The polythiols may be aliphatic or aromatic and may be monomeric or polymeric. The polythiols may be used alone or in combination with one another.

Useful polythiols have the formula R-(SH)n, where n is at least 2, and preferably from 2 to 4, and R is an aliphatic or aromatic organic group of valence n. The polythiol (ii) has a plurality of -SH groups that are capable of reacting with the (meth)acryl group of an (meth)acrylated oligomer (ia) or monomer (ib). R may be a polymeric or non-polymeric organic group that has a valence of n and is preferably selected from polyvalent aliphatic compounds having 1 to 30 carbon atoms and optionally one to six heteroatoms of oxygen, nitrogen or sulfur, and optionally one to six ester linkages; R can also be selected from polyoxyalkylenes; polyesters; polyolefins; polyacrylates; and polysiloxanes. With respect to n, it will be recognized that mixtures of mono-, di- and higher thiols may be used and "n" may represent a non-integral average equal to at least 2.

Specific examples of useful polythiols include dimercaptodiethyl sulfide; 1,6-hexanedithiol; 1,8-dimercapto-3,6-dithiaoctane; propane-1,2,3-trithiol; 1,2-bis[(2-mercaptoethyl)thio]-3-mercaptopropane; tetrakis(7-mercapto-2,5-dithiaheptyl)methane; and trithiocyanuric acid.

Another useful class of polythiols includes those obtained by esterification of a polyol with a terminally thiol-substituted carboxylic acid (or derivative thereof such as esters or acyl halides) including α- or β-mercaptocarboxylic acids such as thioglycolic acid or β-mercaptopropionic acid.

Useful examples of compounds thus obtained include ethylene glycol bis(thioglycolate), pentaerythritol tetrakis(3-mercaptopropionate), ethylene glycol bis(3-mercaptopropionate), trimethylolpropane tris(thioglycolate), trimethylolpropane tris(3-mercaptopropionate), pentaerythritol tetrakis(thioglycolate), all of which are commercially available. A specific example of a preferred polymeric polythiol is polypropylene ether glycol bis(3-mercaptopropionate) which is prepared from polypropylene-ether glycol (e.g. Pluracol™ P201, BASF Wyandotte Chemical Corp.) and 3-mercaptopropionic acid by esterification. Poly-2-mercaptoacetate or poly-3-mercaptopropionate esters, particularly the trimethylolpropane triesters or pentaerythritol tetraesters are preferred.

Thiol terminated polysulfide resins may also be employed. Particularly useful highly functional polythiols include pentaerythritol tetrakis(3-mercaptopropionate) (PETMP), and trimethylolpropane tris (3-mercaptopropionate) (TMPTMP).

Other types of thiol compounds also suitable for the current invention are described in US 7521015 [41-45], US 5608115 (from column 2 line 57 to the end of column 40), US 5908876 (column 4 lines 23-40; column 5 lines 19-45), US 5326501 (from column 1 line 65 to the end of column 12), US 6310161 (from column 12 line 47 to column 14 line 3) and WO2007131145 [0030-0069].

The composition of the present invention may vary in amounts of components. In general, the molar amounts of (meth)acrylate groups from (meth)acrylate comprising oligomers and/or monomers are in excess of the amounts of thiol groups from the polythiol compound. At equimolar amounts, the glass transition temperature of the resulting cured composition is too low to be useful in most composite applications. The amounts of the two major components, the free-radically polymerizable ethylenically unsaturated groups of the (meth)acrylate oligomer and/or monomer and thiol groups from the polythiol, may vary according to their molar equivalence in a ratio of about 50:1 to 2:1 of free-radically polymerizable ethylenically unsaturated groups to thiol groups, preferred from about 20:1 to 3:1.

In an embodiment, the molar ratio between the (meth)acrylate groups of the at least one (meth)acrylate oligomer (ia) and/or monomer (ib) and the thiol groups from the at least one polythiol (ii), may be from 50:1 to 2:1.

A variety of photoinitiators can be used in the practice of this invention. The photoinitiator improves the rate of cure and percent conversion of the curable compositions, but the depth of cure (of thicker coatings or shaped articles) is deleteriously affected as the photoinitiator attenuates the transmitted light that penetrates the thickness of the sample. Additionally, the use of photoinitiators may lead to an increased yellowing and reduced transmission in optical articles and is therefore not preferred. The photoinitiator, when present, is used in an amount of less than 10 weight %, preferably less than 4 weight %, more preferably less than 2 weight %, even more preferably less than 1 % and most preferably less than 0.5% by weight with respect to composite resin matrix composition (a).

Representative, non-limiting examples of the photoinitiators include benzophenone derivatives, acylphosphine oxide, bis-acylphosphine oxide, and α-hydroxy ketone.

Representative non-limiting examples of α-hydroxy ketones include 2-hydroxy-2-methyl-1-phenyl-propan-1-one, 1-[4-2-hydroxyethoxy)-phenyl]-2-hydroxy-2-methyl-propane-1-one, 1-hydroxycyclohexylphenylketone, camphorquinone, and combinations thereof. Bis-acylphosphine oxides and acylphosphine oxides are well known materials that are disclosed, for example, in U.S. Pat. Nos. 4,737,593; 4,792,632; 5,399,770; 5,472,992; and 6,486,228. A representative non-limiting example of an acylphosphine oxide is diphenyl(2,4,6-trimethylbenzoyl)phosphine oxide.

A representative non-limiting example of a bisacylphosphine oxide is phenylbis(2,4,6-trimethylbenzoyl)-phenylphosphineoxide. Combinations of bisacylphosphine oxide and acylphosphine oxides can be employed, such as a combination of diphenyl(2,4,6-trimethylbenzoyl)phosphine oxide and phenylbis(2,4,6-trimethylbenzoyl)-phenylphosphineoxide.

In an embodiment, said resin composition (a) may comprise i) 60 to 99.5 wt. %, preferably 70 to 99 wt.%, more preferably 75 to 95 wt.% of said at least one (meth)acrylated oligomer (ia) and/or monomer (ib), ii) 0.5 to 40 wt. %, preferably 1 to 30 wt.%, more preferably 5 to 25 wt.% of said at least one polythiol (ii), and iii) 0 to 10 wt % of said one or more photo- and/or thermal initiators (iii), wherein the weight percentages are calculated on the total amount of the components (i), (ii) and (iii). These proportion ranges are particularly well suited to obtain resin composition approaching the refractive index of transparent filler material. Matching said refractive index can then simply be a question of fine tuning said proportions within said ranges.

The transparent filler material (b) may be any transparent filler and can be in the form of a fibrous, platy, granular or powdery substance usually used to reinforce the resin composition. The transparent filler material can be inorganic such as but not limited to glass, silica, quartz, metal oxide or organic such as but not limited to polyester, nylon, acrylic and cellulose type of reinforcement material. Preferred are glass types of reinforcement material such as glass beads, glass microspheres, glass flakes, glass fibers, glass powders, and milled glass species.

In an embodiment, said filler material (b) may be a reinforcement material (b) such as e.g. a fibrous material. This is advantageous because the use of a reinforcement material permits to improve the mechanical strength of the composite sufficiently to permit its uses in places where both impact resistance and optical transparency are required such as e.g. windows and canopies in aircrafts. This permits the composite to compete advantageously with glass and plexiglass.

In an embodiment, said reinforcement material (b) may be a fibrous reinforcement material (b). In an embodiment, said filler material (b) may be present in an amount of at least 0.1wt%, preferably at least 1wt%, more preferably at least 5wt%, most preferably at least 10wt% relative to the total weight of the resin composition (a) and the filler material (b).

In an embodiment, said filler material (b) may be present in an amount of at most 90wt%, preferably at most 75wt%, more preferably at most 70wt% and most preferably at most 60wt% relative to the total weight of the resin composition (a) and the filler material (b).

Any minimal amount cited above may be combined with any maximal amount cited above.

For instance, the composite composition may comprise at least 1wt% and at most 90wt% or at least 5wt% and at most 70wt% or at least 10wt% and at most 60wt% of a filler material (b).

In an embodiment, the filler material (b) may be in an amount of 5 vol% to 60 vol% of the volume of the composite composition.

Preferably, the fibrous reinforcing material (b) may be a fibrous glass material. Examples of suitable fibrous glass materials include but are not limited to glass fibers and glass fabrics (e.g. glass cloths and nonwoven glass fabrics). Among them, glass fibers, glass cloths and nonwoven glass fabrics are preferred in view of their being highly effective in reducing the coefficient of linear expansion. Glass cloths are most preferred. As for the glass species, there may be mentioned E glass, C glass, A glass, S glass, D glass, NE glass, T glass, quartz, low inductivity glass, high inductivity glass and so forth. Preferred among them are E glass, S glass, T glass and NE glass, which are readily available. In cases where a glass cloth or nonwoven glass fabric is used as the fibrous reinforcing material, the manner of weaving of filaments is not restricted but includes plain weave, moss stitch-like weave, satin weave, and twill weave, among others. Plain weave is preferred, however. Generally, the glass cloth thickness is from 30 to 200 µm, usually from 40 to 150 µm. The glass cloth, nonwoven glass fabric or other glass fiber fabric may be used either in the form of one single sheet or in the form of a laminate comprising a plurality of sheets. In embodiments, three or four sheets may be used.

As an example, the fibrous reinforcement material (b) may be S-Glass type 4522-30" F81 available from Hexcel.

In an embodiment, said at least one transparent filler material (b) may have a refractive index of from 1.45 to 1.60.

Preferably the composite composition comprises also a stabilizer to prevent premature gelling of the composition. These stabilizers may be antioxidants, free-radical scavengers, UV- absorbers, and/or other known stabilizers including for example compounds selected from: hydroquinone type compounds, phenolics, nitrosoamines, thiazines, thioesters, phosphites, antimony compounds, hindered amine light stabilizers (HALS), and the like, including for example: hydroquinone (HQ); 4-methoxyphenol (MEHQ); 4-methoxy-1-naphtol, 2,6-di-t-butyl-4-methylphenol (BHT); 2-methyl-1,4-benzenediol (THQ); phenothiazine (PTZ), tris(N-nitroso-N- phenylhydroxyamine) aluminum salt (NPAL, available from Albemarle Corp.); Additol S 120, Additol S 130 (available from Cytec); CYAN OX ® 425 (available from Cytec Industries Inc.); CYANOX ® 1741 (available from Cytec Industries Inc.); CYANOX ® 1790(available from Cytec Industries Inc.); CYANOX ® 2246(available from Cytec Industries Inc.); CYANOX ® 711 (available from Cytec Industries Inc.); CYANOX ® 1212 (available from Cytec Industries Inc.); CYANOX ® LTDP (available from Cytec Industries Inc.); CYANOX ® STDP (available from Cytec Industries Inc.); CYANOX ® 2777 (available from Cytec Industries Inc.); CYANOX ® XS4(available from Cytec Industries Inc.); CYASORB ® UV-2337(available from Cytec Industries Inc.); CYASORB ® UV-5411 (available from Cytec Industries Inc.); CYASORB ® UV-594 (available from Cytec Industries Inc.); CYASORB ® UV-9 (available from Cytec Industries Inc.); CYASORB ® UV-24 (available from Cytec Industries Inc.); CYASORB ® UV-531 (available from Cytec Industries Inc.); CYASORB ® UV- 2126 (available from Cytec Industries Inc.).

The composite material may also include additional ingredients such as performance enhancing or modifying agents. The performance enhancing or modifying agents, by way of example, may be selected from flexibilizers, toughening agents/particles, core shell rubbers, additional thermoplastic or thermosetting oligomers or polymers, flame retardants, wetting agents, pigments/dyes, flame retardants, plasticizers, UV absorbers, anti-fungal compounds, fillers, viscosity modifiers/flow control agents, tackifiers, stabilizers, and inhibitors (such as in US 8263503). Examples of toughening agents are described in US 8263503. Note that in order to keep transparency the composition of the mixture is preferably adjusted so that the refractive index of the resin matches sufficiently the refractive index of the transparent filler material.

In a second aspect, the present invention relates to a transparent composite article comprising:
a. a resin matrix (a') obtainable from the crosslinking of:
   i. at least one (meth)acrylated oligomer (ia) and/or monomer (ib), and
   ii. at least one polythiol (ii),
   optionally in the presence of, one or more photo- and/or thermal initiators (iii), and
b. at least one transparent filler material (b) within said resin matrix (a').

The compounds (ia), (ib), (ii), (iii), and (b) may be as defined in any embodiment of the first aspect.

In an embodiment, the transparent composite article may be a sheet having a thickness of from 50 µm to 1 cm, preferably from 50 µm to 5 mm, more preferably from 50 µm to 2 mm and having a light transmittance greater than 60 % and preferably greater than 70% measured at a wavelength of 550 nm.

In a third aspect, the present invention relates to a process for forming a composite composition according to any embodiment of the first aspect, comprising contacting I) a resin composition (a) and II) a transparent filler material (b), the resin composition (a) comprising
i. at least one (meth)acrylated oligomer (ia) and/or monomer (ib),
ii. at least one polythiol (ii), and
iii. optionally, one or more photo- and/or thermal initiators (iii).

The compounds (ia), (ib), (ii), and (iii) may be as defined in any embodiment of the first aspect.

In an embodiment, said contacting step may be performed by a liquid composite manufacturing process. In an embodiment of the third aspect, said liquid composite manufacturing process may be selected from spray-up, hand layup, resin infusion, vacuum bagging, pultrusion, filament winding, and stereolithography.

In an embodiment of the third aspect, said resin infusion may be selected from resin transfer molding (RTM), vacuum assisted resin transfer moulding (VARTM), Resin infusion under flexible tooling (RIFT) structural reaction injection molding (SRIM), and Seemann Composites Resin Infusion Molding Process (SCRIMP).

In a fourth aspect, the present invention relates to a process for forming a transparent composite article comprising curing the composite composition according to any embodiment of the first aspect.

The composite can be cured by exposing the composite material to actinic radiation.

Various types of actinic radiation can be used such as ultraviolet (UV) radiation, gamma radiation, and electron beam. A preferred means of radiation curing is ultraviolet radiation. Any ultraviolet light source, as long as part of the emitted light can be absorbed by the photo-initiator (system), may be employed as a radiation source, such as, a high or low-pressure mercury lamp, a cold cathode tube, a black light, Xenon lamp, an ultraviolet LED, an ultraviolet laser, and a flash light.

Of these, the preferred source is one exhibiting a relatively long wavelength UV-contribution having a dominant wavelength of 300-400 nm. Specifically, a UV-A light source is preferred. Such types of light sources are described in US 7268172. They can also be cured by electron-beam irradiation, allowing the use of compositions free of photoinitiator.

Curing of said composite composition can also be done by thermal heating whereby the polymerization reaction is initiated by a thermal radical initiator. Such types of initiators are described in US 6342545. Such type of initiators are commercially available from Dupont and Arkema under the under the tradenames "VAZO", and "LUPEROX.

Curing time and conditions may vary according to the constituents of the composition, the thickness of the composite and the active energy ray source used. Usually curing is achieved by irradiation for about 10 sec to about 30 min. Further, for the purpose of completing the curing reaction, a heat treatment may be carried out after irradiation with active energy rays.

In an embodiment, said article may be a transparent sheet and said curing may be operated by sandwiching said composite composition between two flat substrates, at least one of which being transparent to actinic radiations, and by exposing said composite composition to said actinic radiations through said transparent flat substrate.

In a fifth aspect, the present invention relates to a resin composition (a) comprising
ia. optionally at least one (meth)acrylated oligomer (ia),
ib. at least one (meth)acrylated monomer (ib),
ii. at least one polythiol (ii), and
iii. optionally, one or more photo- and/or thermal initiators (iii),
   wherein at least one of said at least one (meth)acrylated monomer (ib) is prepared from:
   (d) at least one polycyclic polyol (d),
   (e) optionally, at least one linking compound (e) for linking the at least one polycyclic polyol (d) with at least one (meht)acrylating compound (f),
   (f) at least one (meth)acrylating compound (f).

The components (ia), (ib), (ii), (iii), (d), (e) and (f) may be as defined in any embodiment of the first aspect.

Such a resin composition (a) may have the advantage to be particularly well suited for use with a transparent filler material (b) to obtain a composite composition according to the first aspect.

In a sixth aspect, the present invention relates to a kit of parts comprising
a. a resin composition (a), comprising
   i. at least one (meth)acrylated oligomer (ia) and/or monomer (ib),
   ii. at least one polythiol (ii), and
   iii. optionally, one or more photo- and/or thermal initiators (iii), and
b. at least one transparent filler material (b).

The components (ia), (ib), (ii), (iii), and (b) may be as defined in any embodiment of the first aspect.

In a seventh aspect, the present invention relates to a substrate coated with a composite composition according to the first aspect of the present invention. The composite composition can be cured or not cured. The substrate can be coated with a layer of a composite composition according to the first aspect of the present invention. The substrate can be any substrate. For instance, the substrate can be selected from wood, metal, plastics, paper, leather, or textile. The substrate can also be a composite comprising a matrix resin and a filler. This last composite does not need to be according to the present invention.
The invention will now be described in more details in the examples below, which in no way are intended to be limiting.

Throughout the invention and in particular in the examples the following measuring methods have been applied.

Viscosity: Cone & plate viscosity at a given temperature, usually 25°C, and a given rotation speed of the spindle, also referred to as shear rate.

Renewable Raw Material Content: The Renewable Raw Material Content is calculated as the weight ratio of the renewable raw materials versus the total weight of raw materials.

Glass transition temperature (Tg) and storage modulus (E') from DMA (ASTM E1640): The glass transition temperature and storage modulus of the isolated coating pieces was measured by dynamic thermomechanical analysis using a DMA800 instrument of TA Instruments. Rectangular samples (6 mm x 9 mm x 0.8 mm) were cut from the coating and clamped vertically in the sample holder for tensile deformation. The frequency of the sinusoidal strain was 1 Hz and the amplitude was typically between 0.3% and 1%. The heating rate was 3 °C min⁻¹. The temperature at the maximum of the loss modulus peak was used to establish the glass transition temperature (Tg).

Flexural modulus and strength - three point bending test (ASTM D790): Flexural strength and modulus are determined by three point bending test. A sample of following dimension (45 mm x 10 mm x 0.8 mm) is placed on supports and a center load is applied until failure occurs and the load of failure is the ultimate flexural strength. Cross-head speed of center load is 10 mm/min. Measurements are done at 22°C and at a relative humidity of 55 %.

Fiber content: Composite samples were burned at 615 °C in a muffle furnace for 1 hour in order to bum off the resin and to determine the percentage of the components.

Volume contraction: The volume contraction of UV-cured resins is determined by comparing the density of the liquid resin before cure, **ρℓ**, and the solid coating after cure **ρS.** The volume contraction (shrinkage) is then calculated according to **(ρℓ** / ρs -1).

The liquid density of the dispersion was measured with a calibrated pycnometer. The density of the cured coating was determined by immersion of a piece of UV-cured resin in the gradient density column (Davenport Instruments). The density column was prepared by mixing carefully degassed solutions of sodium bromide (20 and 45 w/w%). The column was calibrated in the range 1.25 -1.35 g cm⁻³ using standard marker floats. The position of the samples suspended in the column was recorded after 48 h. All density measurements were conducted at 23.0 ± 0.5 °C.

The coatings were prepared using an exposure period of 5' to UV-A light followed by a thermal annealing step of 1 hour at 80°C.

Light transmittance: The light transmittance is the fraction of incident light (electromagnetic radiation) at a specified wavelength that passes through a sample. Herein, the light transmittance was measured using a HP 8452A Diode array spectrometer using a Tungsten lamp at 400 and 550 nm through the 800 µm thick composite material.

Haze %: The haze (%) is measured on four points of the 800 µm composite material with a haze meter (XL-211 Hazegard Hazemeter from BYK Gardner). The average haze was calculated.

Resin refractive index: Refractive index measurement was done at the wavelength 589 nm at 25°C using an Atago model 1T refractometer at 20°C.

Cured film refractive index: Cured film refractive index was measured on a 150 µm thick film with Abbe refractometer Atago model 1T at 20°C using 1-bromonaphtalene as contact fluid.

Residual stress: Residual stress measurements were conducted according to the prescriptions of the ASTM method "Standard Test Method for Measurements of Internal Stresses in Organic Coatings by Cantilever (Beam) Method, ASTM Standard, D6991-05, American, Society for Testing and Materials, 2005". However, the application and the conditions relevant to radiation-curable coatings are not detailed in the ASTM document and were thoroughly described by P. Roose in the paper "Residual Stress in Radiation-cured Acrylate coatings" Reactive & Functional Polymers 73 (2013) 323-331.

### Examples:

### Synthetic examples

### Synthetic example 1 : Polythiol 1

Pentaerythritol Tetra(3-mercaptopropionate) (PTM) (418 g, 0.86 mole) was weighed into a 2,000 ml, three neck round bottom flask. Tricyclodecanedioldiacrylate (131 g, 0.43 mole) and Vazo 52 (2.09 g) were weighed into a 500 ml addition funnel equipped with teflon stopcock. The flask containing the PTM was heated to approximately 70° C under agitation. The addition funnel containing the monomer and Vazo 52 was placed on the second neck of the flask and a slow drip was started. A reaction exotherm was immediately obtained and the addition rate was controlled so that the exotherm temperature did not exceed 75° C. After addition of the PTM the reaction mixture was stirred for 3 hr at 70°C. After this, a polythiol compound was obtained with a refractive index of 1.536, measured at 25° C and a viscosity of 29940 mPa.s at 25° C.

### Synthetic example 2 : Polythiol 2

Pentaerythritol Tetra(3-mercaptopropionate) (PTM) (782 g, 1.6 mole) was weighed into a 2,000 ml, three neck round bottom flask. Tricyclodecanedioldiacrylate (122.6 g, 0.40 mole), phenylphenoxyethyl acrylate (107.3 g, 0.4 mole) and Vazo 52 (3.91 g) were weighed into a 500 ml addition funnel equipped with teflon stopcock. The flask containing the PTM was heated to approximately 70° C. under agitation. The addition funnel containing the monomers and Vazo 52 was placed on the second neck of the flask and a slow drip was started. A reaction exotherm was immediately obtained and the addition rate was controlled so that the exotherm temperature did not exceed 75° C. After addition of the PTM the reaction mixture was stirred for 3 hr at 70°C. After this, a polythiol compound was obtained with a refractive index of 1.5410, measured at 25° C and a viscosity of 7243 mPa.s at 25° C.

### Synthetic example 3 : Polythiol 3

Pentaerythritol Tetra(3-mercaptopropionate) (PTM) (488.6 g, 1 mole) was weighed into a 2,000 ml, three neck round bottom flask. Divinylbenzene (65.1 g, 0.50 mole) and Vazo 52 (2.77 g) were weighed into a 500 ml addition funnel equipped with teflon stopcock.The flask containing the PTM was heated to approximately 70° C. under agitation. The addition funnel containing the monomers and Vazo 52 was placed on the second neck of the flask and a slow drip was started. A reaction exotherm was immediately obtained and the addition rate was controlled so that the exotherm temperature did not exceed 75° C. After addition of the PTM the reaction mixture was stirred for 3 hr at 70°C. After this, a polythiol compound was obtained with a refractive index of 1.5456, measured at 25° C and a viscosity of 4303 mPa.s at 25° C.

### Synthetic example 4 : acrylated monomer: isosorbide diacrylate

A reactor was charged with 900 grams of isorbide diol (Polysorb P from Roquette) (11,71 eg), 891,9 grams acrylic acid (12,37 eq), 953 grams toluene, 41,25 grams methane sulphonic acid (70%), 0,89 grams Cu2O, 2,5 grams hypophosphorous acid, 0,89 g oxalic acid, 0,18 g triphenylphosphite and 2,72 g methylhydroquinone. The reactor content was heated at 130°C until the rate of reaction slows down as measured by collection of the esterification water. After about 17 hrs when the acid value was less than 30 mg KOH/g, the reactor was cooled down to 60°C and diluted with 371 g toluene. The reactor was charged with water and stirred for 15 minutes. Phases were let to separate at 50-60°C and the aqueous phase decanted. Washes were repeated until a cupper value below 5 ppm was reached. Then 1,58 grams trisnonylphenylphosphite were added and heated till 95°C to distill the remaining water and the toluene. An airsparge of 1 l/hr was maintained. After distillation of the toluene at 95°C and a reduced pressure of 20 mbar, a product with a Cone & Plate viscosity of 560 mPa.s at 25°C was obtained.

### Formulation examples

The resin compositions below where obtained by mixing and stirring the following components:
- (Meth)acrylated oligomer: EBECRYL® 8465 (Urethane acrylate oligomer available by Cytec) or EBECRYL® 4858 (Urethane acrylate oligomer available by Cytec);
- (Meth)acrylated monomers: isobornyl acrylate (IBOA available by Cytec) and/or isosorbide diacrylate (synthetic example 4);
- Initiator Additol CPK (available from Cytec);
- Stabilizer Additol S 120 (available from Cytec); and
- Polythiol compound EBECRYL® 375 (available from Cytec) or a polythiol as obtained in synthetic examples 1-3.

The compositions were degassed in a vacuum chamber and then allowed to cool to room temperature before use.

**Table 1. Resin formulation composition**

| | Comp Ex | Ex 1 | Ex 2 | Ex 3 | Ex 4 | Ex 5 | Ex 6 | Ex 7 | Ex 8 |
|---|---|---|---|---|---|---|---|---|---|
| EBECRYL® 8465 | 11 | 9 | 9 | 9 | 9,5 | 20 | | | |
| EBECRYL® 4858 | | | | | | | 33 | | 75 |
| EBECRYL® 375 | | 18 | 0 | 0 | 0 | 15 | 15 | 10 | 25 |
| Synthetic example 1 | | 0 | 18 | 0 | 0 | | 0 | 0 | 0 |
| Synthetic example 2 | | 0 | 0 | 16 | 0 | | 0 | 0 | 0 |
| Synthetic example 3 | | 0 | 0 | 0 | 15 | | 0 | 0 | 0 |
| IBOA | 22 | 18,5 | 18,5 | 19 | 19 | 15 | 19 | 0 | 0 |
| Isosorbide diacrylate (Synth 4) | 67 | 54,5 | 54,5 | 56 | 56,5 | 50 | 33 | 90 | 0 |
| Additol S 120 | | 0,5 | 0,5 | 0,5 | 0,5 | 0,5 | 0,5 | 0,5 | 0,5 |
| Additol CPK | 0,5 | 0,5 | 0,5 | 0,5 | 0,5 | 0,5 | 0,5 | 0,5 | 0,5 |
| Viscosity (mPa,s at 25°C) | 190 | 228 | 595 | 374 | 313 | 464 | 349 | 443 | 3910 |
| Liquid refractive index 20°C | 1,486 | 1,497 | 1,497 | 1,497 | 1,497 | 1,496 | 1,495 | 1,496 | 1,496 |

### Properties of cured film without reinforcing filler material

A 0.8 mm thick film was prepared as follows. Resin formulations from table 1 were poured on a sodalime glass panel treated with a release coating layer. A spacer of 0.8 mm was put on the bottom plate to control the thickness of the substrate to be generated. After this, the liquid formulation was sandwiched by covering it with a second 4 mm thick releasing agent-treated sodalime glass panel. Finally the sample was exposed for 5 min with UV light from a Panacol UV H-254 lamp put at a height of 10 cm above the top glass panel. The UV irradiance measured under the top glass panel was 47 mW/cm² UV-A and 7 mW/cm UV-V (measured with EIT UV Power Puck). The free film substrate could be obtained by separating the glass panels.

**Table 2 : Refractive index and glass transition temperature of cured resin compositions**

| | Comp Ex | Ex 1 | Ex 2 | Ex 3 | Ex 4 | Ex 5 | Ex 6 | Ex 7 | Ex 8 |
|---|---|---|---|---|---|---|---|---|---|
| Cured refractive index at 20°C | 1,507 | 1,521 | 1,522 | 1,520 | 1,521 | 1,521 | 1,520 | 1,521 | 1,520 |
| Glass transition temperature °C | 135 | 77 | 85 | 92 | 93 | 68 | 64 | 161 | 33 |

Table 2 shows that refractive index of the comparative example significantly differs from the refractive index of the the glass fibers (S-glass Type 4522-30" F811 having a refractive index of 1.52). In examples 1 to 8 the refractive index cured resin matrix is matched with the refractive index of the glass fiber material by the addition of an adequate amount of the polythiol compound.

Residual stress and shrinkage for the cured resin compositions (without fibers) are indicated in table 3.

**Table 3: residual stress and shrinkage of cured resin compositions**

| | Comp Ex | Ex 1 | Ex 2 | Ex 3 | Ex 4 |
|---|---|---|---|---|---|
| Shrinkage (volume contraction %) | -7,31 | -7,29 | -7,52 | -7,16 | -7,67 |
| residual stress (Mpa) | 7 | 1,6 | 1,9 | 1,9 | 1,8 |

Although shrinkage is similar for all compositions 1-4 and comparative, the coating stress is significantly reduced in the examples 1-4. This can be explained by the later gel point in relation to monomer conversion for the thiol-acrylate polymerization. The shrinkage prior to gelation is accommodated by viscous flow with virtually no stress development within the sample. According to (Composites Part A 29A (1998) 455-464), residual stress in composites materials can induce microcracks, which will negatively impact transparency and mechanical properties. -

### Application

Composite sheets were prepared by resin infusion of glass fiber cloth (S-glass Type 4522-30" F81 available from Hexcel - refractive index 1.52) with resin formulations from table 1 (comparative example, examples 1-4).

Composite substrates with a thickness of about 800 µm were prepared by a vacuum infusion method. In order to obtain flat surface on both sides of the substrate, the infusion of the glass fiber plies was done between two releasing agent-treated glass plates covered with a vacuum bag without making use of any peel ply. Cure was completed after 10 min exposure to the UV light from a Panacol UV H-254 lamp put at a height of 10 cm above the top glass panel. The UV irradiance measured under the top glass plate was 47 mW/cm² UV-A and 7 mW/cm² UV-V (measured with EIT UV Power Puck).

3 and 4 fiber plies were used to prepare the composite material.

Fig.1 schematically represents a method for forming a composite composition according to an embodiment of the present invention. An assembly (1) is provided under a UV lamp (2) for curing the resin composition. The assembly is composed of a bottom glass plate (3), on which a first flow mesh (Green flow 75 from Airtech) (4), glass fiber plies (5) and a second flow mesh (4) are provided in series; and of an upper glass plate (9) on top of the glass fiber plies (5) and the flow meshes (4). The assembly is enclosed in a vacuum bag (Ipplon® KM1300 from Airtech) (6). The assembly is provided with a resin inlet (7) and a vacuum outlet (8). The resin enters the assembly (1) by the resin inlet (7) and is contacted with the glass fiber plies (5) by operating vacuum at the vacuum outlet (8).

The UV cured composites were subjected to mechanical testing including a three-point bend test (ASTM D7900) to determine the flexural strength and modulus of the composites and a DMA test to determine the storage modulus and glass transition temperature of the cured composites. The light transmittance was measured using a HP 8452A Diode array spectrometer using a Tungsten lamp 550 nm. Fiber content of the composites was determined by burning off the resin matrix at 615 °C in a muffle furnace for 1 hour.

| | Fiber content (V %) | # of glass fiber plies | flexural modulus (Gpa) | flexural strenght (Mpa) | Haza % | Light transmittance 400 nm (%) | Light transmitance 550 nm (%) |
|---|---|---|---|---|---|---|---|
| Comp Ex | 33 | 3 | 12,4 | 298 | 44 | 17 | 16 |
| Ex 1 | 31 | 3 | 14,7 | 376 | 6,5 | 66 | 87 |
| Ex 2 | 28 | 3 | 9,2 | 305 | 6,3 | 72 | 88 |
| Ex 3 | 30 | 3 | 10,3 | 275 | 7,2 | 62 | 84 |
| Ex 4 | 28 | 3 | 9,4 | 256 | 7 | 64 | 85 |
| Comp Ex | 37 | 4 | 15 | 327 | 52 | 10 | 15 |
| Ex 1 | 40 | 4 | 16,4 | 450 | 8,6 | 65 | 83 |
| Ex 2 | 37 | 4 | 16,4 | 446 | 8 | 68 | 85 |
| Ex 3 | 41 | 4 | 15 | 362 | 11,5 | 60 | 80 |
| Ex 4 | 36 | 4 | 14,6 | 379 | 11 | 61 | 81 |

Examples 1-4 indicate that it is possible to generate transparent composite sheets. A higher light transmission and lower haze % was observed for the composite samples with polythiol compounds compared to reference example not comprising the polythiol compound. The presence of the polythiol did not deteriorate the flexural modulus and flexural strength.

## Claims

1. A transparent composite composition (a) comprising:
a. a resin composition, comprising
i. at least one (meth)acrylated oligomer (ia) and/or monomer (ib),
ii. at least one polythiol (ii), and
iii. optionally, one or more photo- and/or thermal initiators (iii), and
b. at least one transparent filler material (b).

2. The composition according to claim 1, wherein said filler material (b) is a fibrous reinforcement material (b).

3. The composition according to claim 1 or claim 2, wherein said filler material (b) is present in an amount of at least 0.1wt% and at most 90wt% relative to the total weight of the resin composition (a) and the filler material (b).

4. The composition according to any one of the preceding claims, wherein said polythiol (ii) has a refractive index higher than the transparent filler material (b).

5. The composition according to any one of the preceding claims, where the (meth)acrylated oligomer (ia) and/or monomer (ib) comprises a polycyclic acrylate.

6. The composition according to any one of the preceding claims, wherein the resin composition has a first refractive index after curing, wherein the transparent filler material (b) has a second refractive index, and wherein the first refractive index is within 0.01 of the second refractive index.

7. The composition according to any one of the preceding claims, wherein said at least one polythiol (ii) has a refractive index of from 1.46 to 1.70.

8. The composition according to any one of the preceding claims, wherein said at least one transparent filler material (b) has a refractive index of from 1.45 to 1.60.

9. The composition according to any one of the preceding claims, wherein said resin composition (a) comprises i) 60 to 99.5 wt. % of said at least one (meth)acrylated oligomer (ia) and/or monomer (ib), ii) 0.5 to 40 wt. % of said at least one polythiol (ii), and iii) 0 to 10 wt % of said one or more photo- and/or thermal initiators (iii), wherein the weight percentages are calculated on the total amount of the components (i), (ii) and (iii).

10. The composition according to any one of the preceding claims wherein said at least one (meth)acrylated oligomer (ia) and/or monomer (ib) is chosen so that the glass transition temperature of the polymer obtainable from the polymerization of only said at least one (meth)acrylated oligomer (ia) and/or monomer (ib) is greater than 60°C.

11. The composition according to any one of the preceding claims, wherein the filler material (b) is a glass filler material (b).

12. The composition according to any one of the preceding claims, wherein the molar ratio between the (meth)acrylate groups of the at least one (meth)acrylate oligomer (ia) and/or monomer (ib) and the thiol groups from the at least one polythiol (ii), is from 50:1 to 2:1.

13. A transparent composite article comprising :
a. a resin matrix (a') obtainable from the crosslinking of:
i. at least one (meth)acrylated oligomer (ia) and/or monomer (ib), and
ii. at least one polythiol (ii),
optionally in the presence of one or more photo- and/or thermal initiators (iii), and
b. at least one transparent filler material (b) within said resin matrix (a').

14. A process for forming a composite composition according to any one of claims 1-12, comprising contacting I) a resin composition (a) and II) a transparent filler material (b), the resin composition (a) comprising
i. at least one (meth)acrylated oligomer (ia) and/or monomer (ib),
ii. at least one polythiol (ii), and
iii. optionally, one or more photo- and/or thermal initiators (iii).

15. A process for forming a transparent composite article comprising curing the composite composition according to any one of claims 1 to 12.
